# EUROPÄISCHE PATENTSCHRIFT

(11) **EP 2 494 263 B1**
(45) Veröffentlichungstag und Bekanntmachung des Hinweises auf die Patenterteilung: **11.03.2020**
(21) Anmeldenummer: 10770829.9
(22) Anmeldetag: 27.10.2010
(51) Int. Cl.: F21S 2/00, H01L 23/373, H01L 23/15, F21V 29/00, F21K 99/00, H01L 23/36

(54) **ARRAY AUS SKALIERBAREN KERAMISCHEN DIODENTRÄGERN MIT LED´S**
ARRAY OF SCALABLE CERAMIC DIODE CARRIERS HAVING LEDS
MATRICE DE SUPPORTS EN CÉRAMIQUE MODULABLES MUNIS DE DIODES ÉLECTROLUMINESCENTES

(30) Priorität: 27.10.2009 DE 102009046049; 18.12.2009 DE 102009054974
(43) Veröffentlichungstag der Anmeldung: 05.09.2012
(73) Patentinhaber: CeramTec GmbH, 73207 Plochingen (DE)
(72) Erfinder: DOHN, Alexander, 96117 Memmelsdorf (DE); THIMM, Alfred, 95632 Wunsiedel (DE); GREGER, Stefan, 95700 Neusorg (DE); BRAUN, Kurt, 95615 Marktredwitz (DE); VEITL, Armin, 71272 Renningen (DE)
(86) Internationale Anmeldenummer: PCT/EP2010/066211
(87) Internationale Veröffentlichungsnummer: WO 2011/051310

(56) Entgegenhaltungen:
- EP-A1- 2 023 409
- EP-A2- 2 056 014
- WO-A2-2007/107601
- DE-A1-102008 001 221
- US-A1- 2005 207 165
- US-A1- 2008 151 562

## Beschreibung

Die Erfindung betrifft einen Array aus zumindest zwei identischen keramischen Diodenträgern, wobei die keramischen Diodenträger einen keramischen Trägerkörper umfassen, der einstückig mit Wärme abführenden keramischen Kühlelementen verbunden ist, wobei auf der Oberfläche des Trägerkörpers versinterte Metallisierungsbereiche als Leiterbahnen angeordnet sind und auf den Diodenträgern LED's befestigt sind, deren elektrische Anschlüsse mit den Leiterbahnen elektrisch verbunden sind.

Träger für Leistungs-LED's können aus Keramikwerkstoffen wie AIN oder Al2O3, je nach benötigter Wärmeleitfähigkeit, bestehen. Alternativ können Metallträger aus metallischen Werkstoffen wie Al verwendet werden, die aber wegen ihrer elektrischen Leitfähigkeit vor dem LED-Aufbau nichtmetallisch kaschiert werden müssen bzw. die LED's müssen auf einzelnen nichtleitfähigen Aufbauten (Trägerplatten) montiert werden, was dann trotz der guten Wärmeleitung des metallischen Kühlkörpers wegen der schlechten Wärmeleitfähigkeit von Klebern und Kunststoffen (typisch unter 3 W/mK) die benötigte Montagefläche (und Kühlfläche) steigen lässt oder die Packungsdichte der Leistungs-LED's absenkt.

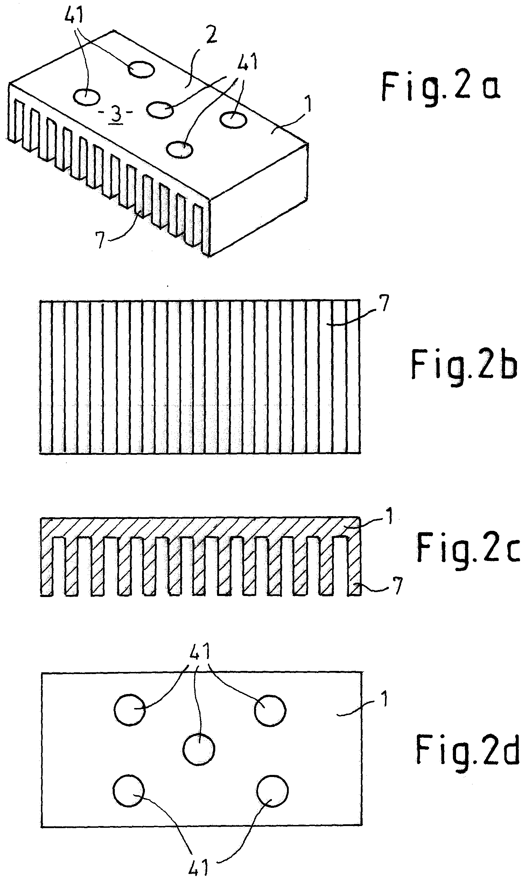

Aus der WO 2007/107601 A2, als nächstliegender Stand der Technik, sind keramische Kühlkörper 1 (siehe Figur 2a bis 2d) bekannt, die auch als heatsink bezeichnet werden. Diese Kühlkörper 1 bestehen aus einem keramischen Trägerkörper 2, der einstückig mit Wärme abführenden Kühlelementen 7 (auch als Finnen bezeichnet) versehen ist, wobei auf der Oberfläche 3 des Trägerkörpers 2 versinterte Metallisierungsbereiche 41 aufgebracht sind, so dass der Kühlkörper 1 als Platine einsetzbar ist. WO 2007/107601 A2 erwähnt auch einen Array aus Trägerkörpern.

Die Metallisierungsbereiche 41 bestehen bevorzugt aus Wolfram und sind chemisch vernickelt. Figur 2a zeigt den Trägerkörper 2 mit den Kühlelementen 7 in dreidimensionaler Ansicht und Figur 2b zeigt eine Aufsicht von unten auf die Kühlelemente 7. Figur 2c zeigt einen Längsschnitt und Figur 2d die Oberfläche 3 des Kühlkörpers 1.

EP 2 056 014 A2 zeigt keinen Trägerkörper der einstückig mit Wärme abführenden keramischen Kühlelementen verbunden ist und auch keine versinterten Metallisierungsbereiche als Leiterbahnen. Beide Maßnahmen sind jedoch extrem wichtig für die Ableitung der Wärme der LED's.

Der Erfindung liegt die Aufgabe zugrunde, ein Array nach dem Oberbegriff des Anspruchs 1 so zu verbessern, dass mit einfachen Mitteln das Licht der LED's in beliebige Richtungen fokussiert werden kann.

Erfindungsgemäß wird diese Aufgabe durch die Merkmale des Anspruchs 1 gelöst.

Dadurch, dass die Diodenträger in einen Rahmen bevorzugt aus Metall oder Kunststoff eingesetzt sind und der Rahmen flexibel ausgebildet ist, kann mit einfachen Mitteln das Licht der LED's in beliebige Richtungen fokussiert werden.

Zumindest sind zwei identische keramische Diodenträger zu einem Array verbunden. Es brauchen dadurch nur identische keramische Diodenträger hergestellt werden, die zur Herstellung des Beleuchtungskörpers zu einem Array miteinander physisch und elektrisch verbunden werden. Unter einem Array wird eine Anordnung von gleichartigen Elementen (hier Diodenträger) in einer festgelegten Art und Weise verstanden.

Erfindungsgemäß sind die Diodenträger in einen Rahmen bevorzugt aus Metall oder Kunststoff eingesetzt. Der Rahmen dient als Aufnahmevorrichtung für die Diodenträger. Der Rahmen kann flächig aber auch dreidimensional ausgeführt sein.

Bevorzugt weisen die Diodenträger Stecker und/oder Buchsen als elektrische und/oder mechanische Verbindungselemente auf, mit denen benachbarte Diodenträger direkt oder indirekt miteinander verbunden sind. In diesem Fall kann ein Rahmen entfallen, wenn die Stecker und Buchsen diese Funktion übernehmen. Die Stecker und/oder Buchsen können aber auch nur zur elektrischen Verbindung der Diodenträger miteinander benutzt werden. Zur elektrischen Verbindung müssen die Pole der Stecker und/oder Buchsen mit den Leiterbahnen bzw. Metallisierungsbereichen verbunden sein.

In einer bevorzugten Ausführungsform sind die Stecker Stifte, insbesondere nach der Norm GU 5,3 und sind die Buchsen an die Stifte angepasst. Auch bei dieser Ausführungsform übernehmen die Stifte und Buchsen sowohl die mechanische als auch die elektrische Verbindung.

In einer alternativen bevorzugten Ausführungsform sind die Diodenträger über separate Verbindungselemente miteinander verbunden. Auch diese Verbindungselemente können elektrische und/oder mechanische Verbindungselemente sein, bzw. beide Funktionen (mechanische und elektrische Verbindung) erfüllen.

In einer bevorzugten Ausführungsform ist zumindest an einem Rand der Diodenträger ein Streifen ohne Metallisierungsbereiche und LED's angeordnet. Dieser Streifen bildet eine Keramik-Feder zur Befestigung an einem Rahmen oder auch einer Schiene. Zumindest zwei Schienen bilden dann den Rahmen.

Bevorzugt weist der Streifen zur Befestigung mit einer Schraube zumindest eine Aussparung auf. Diese Aussparung ist bevorzugt halbkreisförmig ausgebildet und ist bezüglich der Länge des Streifens in der Mitte angeordnet. Auf der gegenüberliegenden Seite des Diodenträgers ist ebenfalls ein Streifen mit einer Ausnehmung angeordnet, wobei sich die Aussparung an der gleichen Stelle befindet.

In einer bevorzugten Ausführungsform dient der Rahmen auch zugleich als Stromzufuhr für die LED's. Hierzu muss der Rahmen aus einem elektrisch leitenden Material bestehen, zum Beispiel aus einem Metall.

Erfindungsgemäß ist der Rahmen flexibel ausgebildet, wodurch leicht eine konvexe oder konkave Anordnung der Diodenträger zu erreichen ist. So können zum Beispiel die Diodenträger konkav zueinander montiert werden, so dass das Licht der LED's in etwa 100 cm Entfernung fokussiert wird. Das Array ist zur flächenhaften Beleuchtung eben und zur punktförmigen Beleuchtung auf der Seite der LED's konkav gebogen.

Die Diodenträger sind in den Rahmen bevorzugt auswechselbar eingebaut, eingesteckt, eingehängt oder eingeklemmt, so können defekte Diodenträger leicht ausgewechselt werden und das Array ist leicht herzustellen.

In bevorzugter Ausführungsform sind auf dem Diodenträger zueinander parallele Leiterbahnen angeordnet. Jeweils zwei benachbarte Leiterbahnen bilden die Stromzufuhr für die LED's.

Erfindungsgemäß wird ein Array mit zumindest zwei identischen keramischen Diodenträgern beschrieben, wobei auf den Diodenträgern LED's befestigt sind, deren elektrischen Anschlüsse mit den Leiterbahnen der Diodenträger elektrisch verbunden sind.

Keramische Kühlkörper, beispielsweise aus AIN (mit 180 W/mK) als Platte mit keramischen Finnen auf der Rückseite monolithisch ausgebildet, sind wegen der direkten Montierbarkeit der LED's auf den metallisierten Kühlkörpern mit Hilfe von thermisch gut leitfähigen Lötverbindungen (beispielsweise AuSn mit etwa 60-80 W/mK) so leistungsfähig, dass auch mehrere Kühlkörper unmittelbar nebeneinander skalierbar in Größe und Anzahl zu einem Array angeordnet werden können. Dieses Array wird durch einen Rahmen beispielsweise aus Metall mit Klemmen für die einzelnen Kühlkörper zusammengehalten. In einem Array können die Diodenträger in unterschiedlichem Winkel fixiert werden, so dass ein fokussiertes oder ein streuendes Array, oder ein einstellbares Array entsteht. Die Lichtfarben der Dioden können unterschiedlich sein. Zusammen mit einer geeigneten elektrischen Schaltung können die Dioden zu bestimmten Zeiten intermittierend eingeschaltet werden. Die Kühlkörper können konvektionsgekühlt oder flüssigkeitsgekühlt sein.

Nachfolgend wird die Erfindung anhand von Figuren weiter erläutert.

Figur 2a bis 2d zeigen keramische Kühlkörper 1 gemäß WO 2007/107601 A2, wie weiter oben beschrieben.

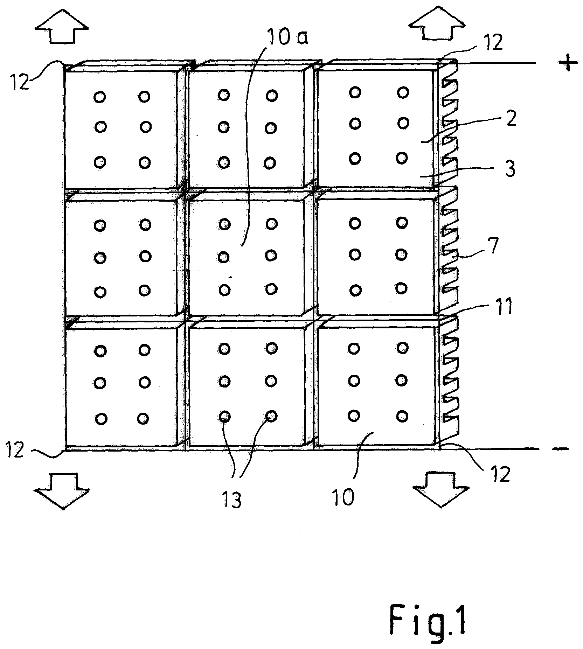

Die Figur 1 zeigt neun identische quadratische keramische Diodenträger 10 mit jeweils 4^{∗}4 cm Schaltungsfläche, bestückt mit jeweils sechs LED's 13 zu je 1 Watt in gleicher Farbe, die zu einem Array verbunden sind. Die einzelnen Diodenträger 10 sind in einen Metallrahmen 11 (nur schematisch gezeigt) eingebaut oder eingehängt, der auch zugleich als Stromzufuhr für die LED's 13 (die Stromzufuhr ist in dieser Figur nicht gezeigt) dient. An den vier Ecken 12 wurde der Metallrahmen 11, bzw. das Array im Gegensatz zum mittleren Diodenträger 10a etwas angehoben, so dass die Diodenträger 10 konvex (in der Figur nicht zu sehen) zueinander montiert sind. Als Folge der konvexen Anordnung fokussiert das Licht der LED's des Array in etwa 100 cm Entfernung von den Diodenträgern 10.

Das Array aus den Diodenträgern 10 dient zur flächigen Beleuchtung, kann aber, wie beschrieben, auch zur punktförmigen Beleuchtung eingesetzt werden. Hierzu werden die Diodenträger 10 in unterschiedlichen Winkeln so im Metallrahmen 11 fixiert, dass sich ein fokussiertes Licht ergibt.

Durch Hochklappen der Ecken 12 entsteht zum Beispiel eine parabolische Anordnung mit einem Lichtbrennpunkt. Das Array kann auch eben zur flächenhaften Beleuchtung oder gebogen sein für eine punktförmige Beleuchtung.

Die Diodenträger 10 bestehen aus einem keramischen Trägerkörper 2, der einstückig mit Wärme abführenden Kühlelementen 7 (auch als Finnen bezeichnet) versehen ist, wobei auf der Oberfläche 3 des Trägerkörpers 2 versinterte Metallisierungsbereiche (siehe Figur 2) aufgebracht sind, so dass der Trägerkörper 2 als Platine eingesetzt ist.

Die Metallisierungsbereiche bestehen bevorzugt aus Wolfram und sind chemisch vernickelt.

Bevorzugt ist eine Verwendung des Array im Operationssaal zur Anwendung in der Chirurgie. Weitere vorteilhafte Verwendungsmöglichkeiten sind:
Straßenbeleuchtung
Indoor/Outdoor Objektbeleuchtung
Flutlicht

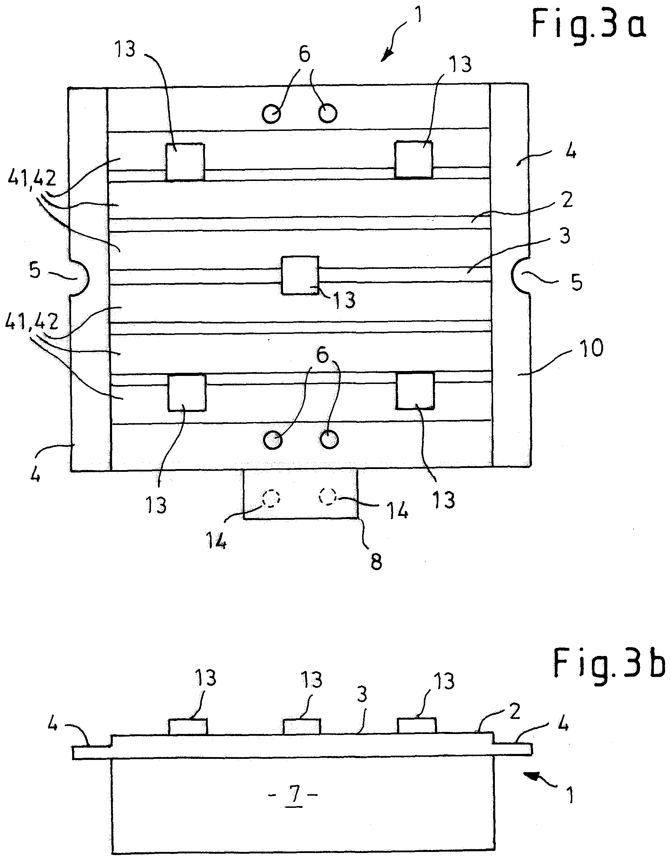

Figur 3a, 3b zeigen einen keramischen Diodenträger 10 in Aufsicht 3a und im Schnitt 3b, der aus einem Kühlkörper 1 bzw. aus einem keramischen Trägerkörper 2 besteht, der einstückig mit Wärme abführenden keramischen Kühlelementen 7, hier Finnen, versehen ist. Diese Kühlelemente 7 sind, wie in Figur 2 gezeigt, auf einer Seite des Trägerkörper 2 angeordnet und stehen kammartig rechtwinklig vom Trägerkörper 2 ab. Auf der Oberfläche 3 des Trägerkörpers 2 sind versinterte Metallisierungsbereiche 41 als Leiterbahnen 42 aufgebracht, so dass der Diodenträger 10 die Funktion einer Platine mit einer äußerst guten Wärmeableitung hat. Auf dem Diodenträger 10 sind in dieser Ausführungsform fünf LED's 13 befestigt, die mit ihren elektrischen Leitungen auf die Metallisierungsbereiche 41 aufgelötet sind. Zur stromleitenden und/oder mechanischen Verbindung zweier oder mehr Diodenträger 10 zu einem Array weisen die Diodenträger 10 Stecker und/oder Buchsen als Verbindungselemente auf, mit denen die Diodenträger direkt oder indirekt miteinander verbunden sind.

In der hier gezeigten Ausführungsform sind die Stecker Stifte 6, insbesondere nach der Norm GU 5,3 und die Buchsen sind an die Stifte angepasst. Figur 3 zeigt eine Ausführungsform mit ausschließlich Steckern, die hier aus Stiften 6 bestehen. Diese Stifte 6, zwei für jeden Stecker, sind am Randbereich des Diodenträgers 10 angeordnet, wobei sich die Stecker 6 an gegenüberliegenden Seiten des Diodenträgers 10 befinden. Zur Verbindung zweier Diodenträger 10 wird hier ein separates Verbindungselement 8 verwendet. Dieses Verbindungselement 8 ist in der hier gezeigten Variante eine rechteckige oder quadratisch geformt Platte mit durchgehenden Bohrungen 14. In diese Bohrungen 14 sind die Stifte 6 am Diodenträger 10 einen elektrischen Kontakt herstellend eingesteckt. Jedes Verbindungselement 8 weist vier Bohrungen 14 auf. Jeweils zwei Bohrungen 14 auf dem Verbindungselement 8 sind miteinander elektrisch verbunden.

Zur Befestigung der Diodenträger 10 in einem Rahmen weisen diese zumindest an einem Rand einen Streifen 4 ohne Metallisierungsbereiche 41 und ohne LED's 13 auf. Dieser Streifen 4 bildet damit eine Keramik-Feder zur Befestigung in einem Rahmen oder auch einer Schiene. Zumindest zwei Schienen bilden dann den Rahmen.

Der Streifen 4 weist zur Befestigung mit bevorzugt einer Schraube zumindest eine Aussparung 5 auf.

## Patentansprüche

1. Array aus zumindest zwei identischen keramischen Diodenträgern (10), wobei die keramischen Diodenträger (10) einen keramischen Trägerkörper (2) umfassen, der einstückig mit Wärme abführenden keramischen Kühlelementen (7) verbunden ist, wobei auf der Oberfläche (3) des Trägerkörpers (2) versinterte Metallisierungsbereiche (41) als Leiterbahnen (42) angeordnet sind und auf den Diodenträgern (10) LED's (13) befestigt sind, deren elektrische Anschlüsse mit den Leiterbahnen (42) elektrisch verbunden sind, **dadurch gekennzeichnet, dass** die Diodenträger (10) in einen Rahmen (11) bevorzugt aus Metall oder Kunststoff eingesetzt sind und der Rahmen (11) flexibel ausgebildet ist.

2. Array nach Anspruch 1, **dadurch gekennzeichnet, dass** die Diodenträger Stecker und/oder Buchsen als elektrische und/oder mechanische Verbindungselemente aufweisen, mit denen benachbarte Diodenträger (10) direkt oder indirekt miteinander verbunden sind.

3. Array nach Anspruch 2, **dadurch gekennzeichnet, dass** die Stecker Stifte (6), insbesondere nach der Norm GU 5,3 sind und die Buchsen an die Stifte (6) angepasst sind.

4. Array nach einem der Ansprüche 1 bis 3, **dadurch gekennzeichnet, dass** die Diodenträger (10) über separate Verbindungselemente (8) miteinander verbunden sind.

5. Array nach einem der Ansprüche 1 bis 4, **dadurch gekennzeichnet, dass** zumindest an einem Rand der Diodenträger (10) ein Streifen (4) ohne Metallisierungsbereiche (41) und LED's (13) angeordnet ist.

6. Array nach Anspruch 5, **dadurch gekennzeichnet, dass** der Streifen (4) zur Befestigung zumindest eine Aussparung (5) aufweist.

7. Array nach einem der vorhergehenden Ansprüche, **dadurch gekennzeichnet, dass** der Rahmen (11) auch zugleich als Stromzufuhr für die LED's (13) dient.

8. Array nach einem der vorhergehenden Ansprüche, **dadurch gekennzeichnet, dass** das Array zur flächenhaften Beleuchtung eben und zur punktförmigen Beleuchtung auf der Seite der LED's (13) konkav gebogen ist.

9. Array nach einem der vorhergehenden Ansprüche, **dadurch gekennzeichnet, dass** die Diodenträger (10) in den Rahmen (11), bevorzugt auswechselbar, eingebaut, eingesteckt, eingehängt oder eingeklemmt sind.

10. Array nach einem der vorhergehenden Ansprüche, **dadurch gekennzeichnet, dass** auf dem Diodenträger (10) zueinander parallele Leiterbahnen (42) angeordnet sind.

## Claims

1. Array consisting of at least two identical ceramic diode carriers (10), the ceramic diode carriers (10) comprising a ceramic carrier body (2) which is integrally joined to heat-dissipating ceramic cooling elements (7), sintered metallization regions (41) being arranged on the surface (3) of the carrier body (2) as conductor tracks (42) and LEDs (13) being attached to the diode carriers (10), the electrical connections of which LEDs are electrically connected to the conductor tracks (42), **characterized in that** the diode carriers (10) are inserted into a frame (11) which is preferably made of metal or plastics material, and the frame (11) is flexible.

2. Array according to claim 1, **characterized in that** the diode carriers comprise plugs and/or sockets as electrical and/or mechanical connecting elements by means of which adjacent diode carriers (10) are directly or indirectly connected to one another.

3. Array according to claim 2, **characterized in that** the plugs are pins (6), in particular according to the standard GU 5.3, and the sockets are adapted to the pins (6).

4. Array according to any of claims 1 to 3, **characterized in that** the diode carriers (10) are connected to one another via separate connecting elements (8).

5. Array according to any of claims 1 to 4, **characterized in that** a strip (4) without metallization regions (41) or LEDs (13) is arranged at least on one edge of the diode carrier (10).

6. Array according to claim 5, **characterized in that** the strip (4) has at least one recess (5) for attachment.

7. Array according to any of the preceding claims, **characterized in that** the frame (11) is also a power supply for the LEDs (13).

8. Array according to any of the preceding claims, **characterized in that** the array is planar for surface illumination and is curved concavely on the side of the LEDs (13) for spot illumination.

9. Array according to any of the preceding claims, **characterized in that** the diode carriers (10) are integrated, inserted, suspended or clamped in the frame (11), preferably so as to be replaceable.

10. Array according to any of the preceding claims, **characterized in that** mutually parallel conductor tracks (42) are arranged on the diode carrier (10).

## Revendications

1. Matrice d'au moins deux supports (10) en céramique identiques pour diodes, les supports (10) en céramique pour diodes comprenant un corps de support (2) en céramique relié de manière monobloc avec des éléments de refroidissement (7) en céramique dissipant la chaleur, des zones de métallisation (41) frittées faisant office de pistes conductrices (42) étant placées sur la surface (3) du corps de support (2) et des diodes électroluminescentes (13), dont les bornes électriques peuvent être reliées électriquement aux pistes conductrices (42), étant fixées sur les supports (10) pour diodes, **caractérisée en ce que** les supports (10) pour diodes sont insérés dans un cadre (11) de préférence en métal ou en plastique et **en ce que** le cadre (11) est réalisé de manière flexible.

2. Matrice selon la revendication 1, **caractérisée en ce que** les supports pour diodes comportent des prises mâles et/ou des prises femelles comme éléments de liaison électriques et/ou mécaniques par lesquels des supports (10) pour diodes adjacents sont reliés directement ou indirectement entre eux.

3. Matrice selon la revendication 2, **caractérisée en ce que** les prises mâles sont des broches (6), en particulier selon la norme GU 5.3, et les prises femelles sont adaptées aux broches (6).

4. Matrice selon l'une des revendications 1 à 3, **caractérisée en ce que** les supports (10) pour diodes sont reliés entre eux par l'intermédiaire d'éléments de liaison (8) séparés.

5. Matrice selon l'une des revendications 1 à 4, **caractérisée en ce qu'**une bande (4) sans zones de métallisation (41) et sans diodes électroluminescentes (13) est disposée au moins sur un bord du support (10) pour diodes.

6. Matrice selon la revendication 5, **caractérisée en ce que** la bande (4) présente au moins un évidement (5) pour la fixation.

7. Matrice selon l'une des revendications précédentes, **caractérisée en ce que** le cadre (11) sert également d'alimentation électrique pour les diodes électoluminescentes (13).

8. Matrice selon l'une des revendications précédentes, **caractérisée en ce que** la matrice est plate pour un éclairage plan et incurvée de manière concave sur le côté des diodes électroluminescentes (13) pour un éclairage ponctuel.

9. Matrice selon l'une des revendications précédentes, **caractérisée en ce que** les supports (10) pour diodes sont installés, enfichés, accrochés ou serrés, de préférence de manière remplaçable, dans le cadre (11).

10. Matrice selon l'une des revendications précédentes, **caractérisée en ce que** des pistes conductrices (42) parallèles les unes aux autres sont disposées sur le support (10) pour diodes.
